# EUROPEAN PATENT APPLICATION

(11) **EP 1 801 969 A1**
(43) Date of publication of application: **27.06.2007**
(21) Application number: 05028273.0
(22) Date of filing: 23.12.2005
(51) Int. Cl.: H03K 3/00

(54) **True single phase clock flip-flop**

(71) Applicant: Infineon Technologies AG, 81669 München (DE)
(72) Inventor: Acharya, Pramod, 80809 München (DE)
(74) Representative: Reinhard - Skuhra - Weise & Partner

(57) **Abstract**

A True Single Phase Clock flip-flop (1) is configured to operate in an evaluating and an hold mode. The TSPC flip-flop (1) comprises as integral parts an input stage (IS) having an input node (A) and a first output node (B), a middle stage (MS) having a second input node (B), an output stage (OS) having a third input node (C), and a reset functional block (2a,2b) being switchable between an activated and an deactivated mode. The reset functional block (2a,2b) resets the flip-flop (1) when activated and is configured to synchronous exit out of reset when switched from its activated to its deactivated mode so that an output signal (Q) of the flip-flop (1) is only up-dated when the flip-flop (1) changes to its next evaluating mode.

## Description

The inventions relates to a True Single Phase Clock (TSPC) flip-flop.

True Single Phase Clock (TSPC) flip-flops have been used in industry since the late 1980s. U.S.-patent 6,448,831 B1 discloses an example of such a TSPC flip-flop which operates as a negative edge-triggered flip-flop and comprises three stages: An input stage, a middle stage, and an output stage. In general, known TSPC flip-flops compromise robustness for speed and tend to be dynamic implementations and hence are normally not suitable for a highly generic standard cell application environment.

It is an object of the present invention to provide a True Single Phase Clock flip-flop which allows a more versatile implementation when integrated with further components to an integrated circuit.

The object is achieved in accordance with the invention by means of a True Single Phase Clock (TSPC) flip-flop configured to operate in an evaluating and an hold (pre-charge) mode, comprising as integral parts: an input stage having an input node and a first output node, a middle stage having a second output node, an output stage having a third output node, and a reset functional block being switchable between an activated and an deactivated mode. The reset functional block resets the flip-flop when activated and is configured to synchronous exit out of reset when switched from its activated to its deactivated mode so that an output signal of the flip-flop is only up-dated when the flip-flop changes to its next evaluating mode. TSPC flip-flops are clocked by a clock signal which alternates between a first state associated with the evaluating mode and a second state associated with the hold mode. Substantially, the output signal of the inventive flip-flop is present at the third node; if necessary, the signal at the third node may be inverted by an inverter. The output signal of the inventive flip-flop can have two states, namely logical value "1", usually associated with a high voltage and logical "0", usually associated with a low voltage. When the inventive flip-flop is reset, then the output signal is set to logical "0". Since the reset function is a synchronous exit out of reset function, the output value of the flip-flop must only be up-dated with the edge of the clock signal changes from its hold mode to its evaluating mode when the reset is deactivated.

Known TSPC flip-flops do not have any integrated reset functions. Should it be required that such a known TSPC flip-flop must have a reset function and especially a synchronous exit out of reset function, then this functionality has to be externally added to the flip-flop layout. Externally added components, however, are likely to increase latency or performance of the flip-flop. TSPC flip-flops are usually used as stand alone devices. If, however, a TSPC flip-flop is integrated to fit into different circuit topologies, then this functionality has to be designed for each of the special applications independently, increasing the complexity of the design and thus the time to develop such a circuit. The inventive TSPC flip-flop on the other hand contains the synchronous exit out of reset functional block as an integrated part. This allows the inventive TSPC flip-flop to be integrated within different circuit topologies without modifying the reset functionality. Since the reset functionality is further an integral part of the inventive TSPC flip-flop, it is possible to assure that the reset functionality does not affect the latency of the flip-flop negatively.

The inventive TSPC flip-flop may particularly be configured so that the third output node is decoupled from the remainder of said flip-flop during a hold mode. Additionally, the reset functional block may comprise a first functional block which forces the second output node to a predefined state so that the third output node is forced to a state corresponding to a reset output signal.

In a restricted version of the inventive TSPC flip-flop, the reset functional block comprises a second functional block which maintains the predefined state of the second output node, when the reset functional block is switched from its activated to its deactivated mode during a certain evaluating mode, up to the hold mode immediately following this certain evaluating mode. This assures that the flip-flop is, when the reset function is switched form "activated" to "deactivated", only up-dated when the flip-flop changes to its next evaluating mode. Preferably, the second functional block comprises a first latch circuit. A latch circuit is a bistable circuit which can be toggled between two states. Preferably, the first latch circuit is a back-to-back inverter. During normal operation of the inventive TSPC flip-flop, i.e. during operation with deactivated reset, the first latch circuit may additionally maintain the state of the second output node during a given evaluating mode. Standard TSPC flip-flops may not have any means to actively hold the respective value during the evaluating mode. Since the inventive reset functional block of the inventive TSPC flip-flop may be designed to actively hold this value, constraints when incorporating the inventive flip-flop in an integrated circuit are less stringent.

In a further restricted version of the inventive flip-flop, it comprises a second latch circuit being connected to the third output node. The second latch circuit, which may be a back-to-back inverter, is able to toggle between a first state and a second state and holds, during the hold mode, the value of the third output node assumed during the evaluating mode preceding this hold mode. The third output node of the inventive TSPC flip-flop is preferably decoupled from the remainder of the flip-flop during a hold mode. Since the second latch circuit holds the value of the third node assumed at an evaluating mode during the following hold mode, an undesired floating of the value of the third output node can be avoided. This allows to use the inventive flip-flop within a relative large range of applications and frequencies.

Depending on the input data, the state of the first output node may float during a given evaluating mode. In order to prevent such a floating, the inventive TSPC flip-flop may comprise a third latch circuit connected to the first output node. The first latch circuit, which may be a back-to-back inverter, is able to toggle between a first state and a second state and holds, during the evaluating mode, the value of the first output node assumed during this evaluating mode.

The TSPC flip-flop is relatively versatile and can be configured for several applications with simple add-on circuits or relative trivial modification of the core circuit. Especially, the inventive TSPC flip-flop can be combined to an integrated circuit, comprising the inventive TSPC flip-flop and a standard cell interface. A state retention circuit may also be added to such an integrated circuit. The inventive flip-flop can also be used as a level shifting flip-flop.

The inventive TSPC flip-flop may have at least one of the following advantages compared to TSPC flip-flops according to the prior art:

The critical path of the inventive TSPC flip-flop, i.e. the path from the input to the output, is not affected significantly by any of the added functionality, relaxing design specifications. Since the flip-flop is a True Single Phase Clock flip-flop, data races are eliminated. The setup and hold time or the setup-hold window can significantly be improved, allowing for more logic stages between to such flip-flops. The skew rate, i.e. the delays between two raise edges minus the delay between two falling edges, may be improved. The reset and an enable mode are fully compliant with standard cell specifications, improving the versatility of the inventive flip-flop. The inventive flip-flop comprises preferably only inverter circuits, pull-up and pull-down devices to realize each functionality. Thus, a relative low supply voltage can be used. Further, when used as a data retention flip-flop, the topology ensures signaling into and out of state retention is relatively simple.

These and other aspects of the invention are apparent from and will be elucidated with reference to the embodiments described hereafter and shown in the drawings, by way of non-limiting examples. The Figures show:
- Fig. 1: is a circuit diagram of an inventive TSPC flip-flop,
- Figs. 2 and 3: are diagram illustrating the reset response of the TSPC flip-flop of Fig. 1,
- Figs. 4 and 5: are integrated circuits containing the flip-flop of Fig. 1.
- Fig. 6: is a circuit diagram of a standard cell interface,
- Fig. 7: is an integrated circuit containing circuit of Fig. 5 and
- Fig. 8: is a circuit diagram of a state retainer interface.

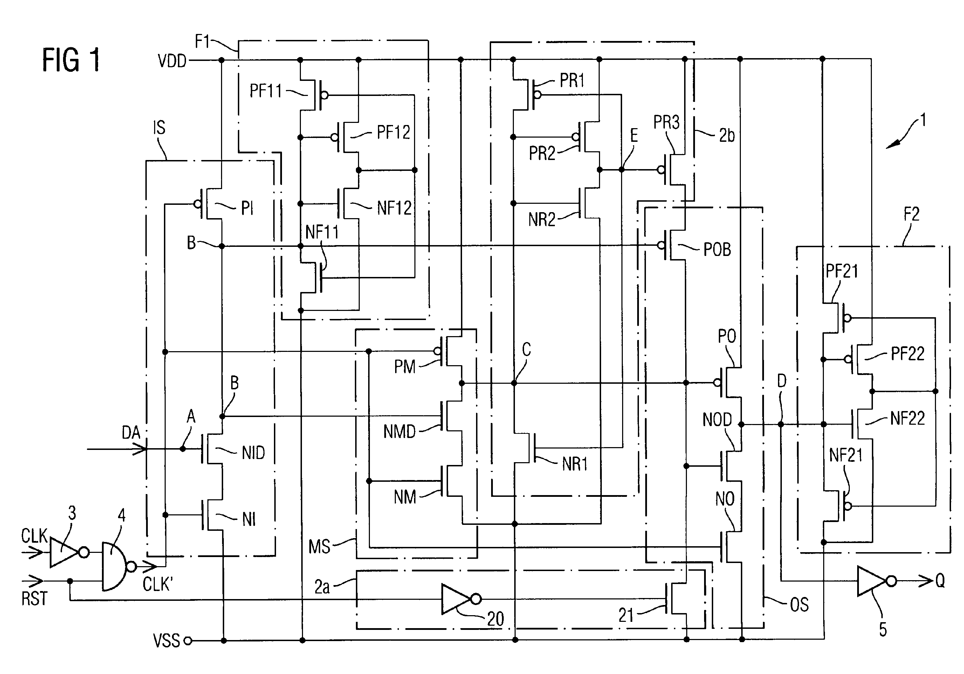

Fig. 1 shows the circuit diagram of a True Single Phase Clock (TSPC) flip-flop 1 including an integrated synchronous exit out of reset circuit. The integrated synchronous exit out of reset circuit comprises a first circuit part 2a and a second circuit part 2b, and is intended to reset the TSPC flip-flop 1 by a reset signal RST on demand. For the exemplary embodiment, the reset function is activated, if the state of the reset signal RST is logical "0" (low) and the reset function is deactivated, if the state of reset signal RST is logical "1" (high).

For the present exemplary embodiment, the flip-flop 1 is clocked by a clock signal CLK and is designed to be in its evaluating mode when the state of the clock signal CLK is logical "1" (high). Thus, the reset circuit is designed for the present exemplary embodiment to let the flip-flop 1 to exit out of its reset only when a leading edge LE of the clock signal CLK for the flip-flop 1 appears.

The flip-flop 1 comprises a first inverter 3 which inverts the clock signal CLK and a NAND gate 4 whose input signals are the inverted clock signal and the reset signal RST. As a result, the output signal CLK' of the NAND gate 4 is logical "1", if the reset is activated, i.e. if the state of the reset signal RST is logical "0", regardless of the state of the clock signal CLK. If the reset function is deactivated, corresponding to a logical "1" of the reset signal RST, then the NAND gate 4 behaves like an inverter and the output signal CLK' of the NAND gate 4 is logical "1", if the clock signal CLK is logical "1", and the output signal CLK' of the NAND gate 4 is logical "0", if the clock signal CLK is logical "0" .

The flip-flop 1 is comprised of an input stage IS, followed by a middle stage MS which is followed by an output stage OS.

The input stage IS comprises a pre-charge P-channel FET PI connected to a positive supply voltage VDD, an evaluating N-channel FET NI connected to a node VSS, and an N-channel FET NID connected between the FETs PI, NI. The node VSS is or may be connected by a non-shown switch to ground. The pre-charge P-channel FET PI and the evaluating N-channel FET NI are each controlled by the NAND gate 4 output signal CLK'. The gate of the N-Channel FET NID is connected to a first node A which represents the input of the input stage IS and the input of the flip-flop 1. Thus, if an input signal DA is applied to the flip-flop 1, then the input signal DA controls the N-channel FET NID of the input stage IS. For the exemplary embodiment, the drains of the pre-charge P-channel FET PI and the N-channel FET NID are connected to a second node B at which the output signal of the input stage IS is present.

The middle stage MS comprises a pre-charge P-channel FET PM connected to the positive supply voltage VDD, an N-channel FET NM connected to node VSS, and an N-channel FET NMD connected between the FETs PM, NM. The pre-charge P-channel FET PM and the N-channel FET NM are each controlled by the NAND gate 4 output signal CLK'. The gate of the N-Channel FET NMD is connected to the second node B. Thus, the signal of node B is the input signal of the middle stage MS. For the exemplary embodiment, the drains of the pre-charge P-channel FET PM and the N-channel FET NMD are connected to a third node C at which the output signal of the middle stage MS is present.

The output stage OS comprises a P-channel FET PO connected to the positive supply voltage VDD, an evaluating N-channel FET NO connected to node VSS, an N-channel FET NOD connected between the FETs PO, NO, and a P-channel FET POB whose drain is connected to the third node C and whose gate is connected to node B. The P-channel FET POB2 is thus controlled by the output signal of the input stage IS. The gates of the P-channel FET PO and the N-channel FET NOD are connected to the third node C. Thus, the output signal of the middle stage MS controls the gate of the N-channel FET NOD. The source of the P-channel FET POB is connected to the second circuit part 2b of the reset circuit and the gate of the N-channel FET NOD as well as the third node C are connected to a the first circuit part 2a of the reset circuit. For the exemplary embodiment, the drains of the P-channel FET PO and the N-channel FET NOD are connected to a fourth node D at which the output signal of the output stage OS is present.

The fourth node D is connected to an inverter 5 whose output signal is the output signal Q of the flip-flop 1.

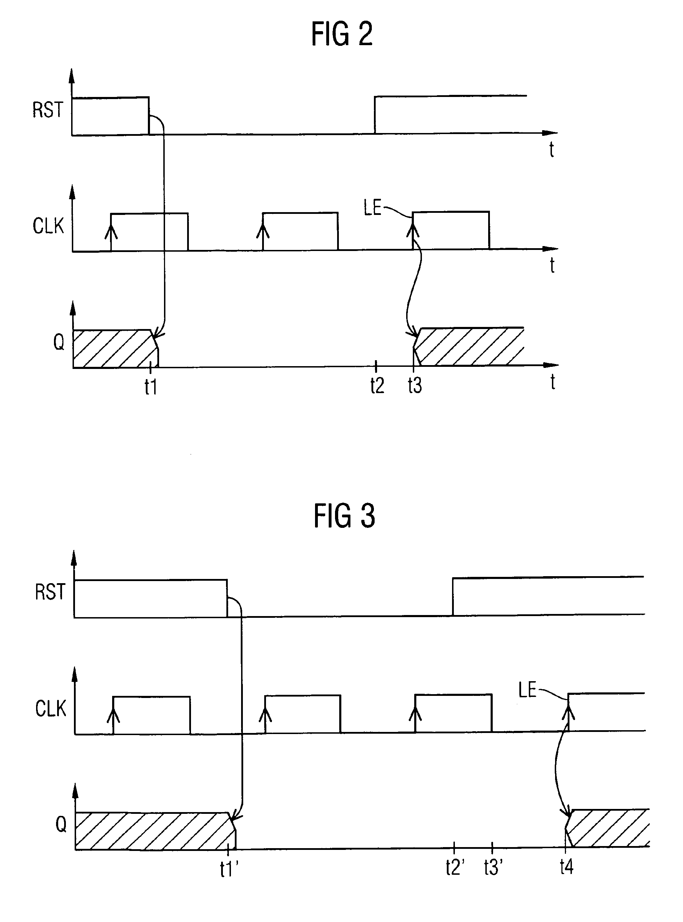

The reset functionality of the flip-flop 1 is also illustrated by Figs. 2 and 3.

When the reset is deactivated, the flip-flop 1 may be in its evaluating or in its hold (pre-charge) mode. The flip-flop 1 is in its evaluating mode, when the clock signal CLK is logical "1" and in its hold mode, when the clock signal CLK is logical "0". If the reset function is deactivated, then the reset signal RST is logical "1". In Fig. 2 reset is shown as deactivated until time t1 and in Fig. 3 reset is shown as deactivated until time t1'.

The reset signal RST is not only fed to the NAND gate 4, but also to the first circuit part 2a of the reset circuit. The first circuit part 2a comprises an inverter 20 and a N-channel FET 21 whose gate is connected downstream to the inverter 20. The inverter 20 inverts the reset signal RST. The source of the N-channel FET 21 is connected to node VSS and the drain of the N-channel FET 21 is connected to the third node C. Consequently, the N-channel FET 21 of the first circuit part 2a conducts, if the reset function is activated, and is inactive, if the reset function is deactivated.

If the reset function is deactivated and the clock signal CLK transits from logical "1" to logical "0", then the flip-flop 1 transits in its hold mode. Then the clock signal CLK and thus the output signal CLK' of the NAND gate 4 are logical "0". The pre-charge P-channel FET PI of the input stage IS and the pre-charge P-channel FET PM of the middle stage MS are conducting and the evaluating N-channel FET NI of the input stage IS, the N-channel FET NM of the middle stage MS, and the N-channel FET NO of the output stage OS are inactive. The P-channel FET PO of the output stage OS is also blocking as the third node C is logical "1". Thus, the fourth node D is decoupled from the remainder of the flip-flop 1 and assumes the state of the preceding evaluating mode.

If the reset function is deactivated and the clock signal CLK transits from logical "0" to logical "1", then the flip-flop 1 is in its transparent evaluating mode and the output signal CLK' of the NAND gate 4 is also logical "1". Then, the pre-charge P-channel FET PI of the input stage IS and the pre-charge P-channel FET PM of the middle stage MS are inactive and the evaluating N-channel FET NI of the input stage IS, the N-channel FET NM of the middle stage MS, and the N-channel FET NO of the output stage OS are conducting. Then, the three stages IS, MS, OS correspond to cascaded inverters followed by a final driver, i.e. the output signal Q equals the input signal DA of the flip-flop 1.

For example, if the input signal DA of the flip-flop 1 is logical "1" during the evaluating mode, then the N-channel FET NID conducts and the second node B becomes logical "0". The P-channel FET PM of the middle stage MS retains undisturbed and the third node C remains logical "1", as it is during the preceding hold mode. Thus, the N-channel FET NOD of the output stage OS conducts and the fourth node D becomes logical "0". The inverter 5 inverts this signal so that the output signal Q of the flip-flop 1 becomes logical "1".

If the input signal DA of the flip-flop 1 is logical "0" during the evaluating mode, then the N-channel FET NID and the pre-charge P-channel FET PI are inactive so that the second node B remains logical "1". Thus, the N-channel FET NMD conducts and the third node C becomes logical "0" so that the P-channel FET PO of the output stage OS conducts.

Consequently, the fourth node D becomes logical "1" so that the output signal Q of the flip-flop 1 becomes logical "0".

For the exemplary embodiment, the flip-flop 1 comprises further two optional functional blocks F1 and F2 for pure static operation. The functional blocks F1 and F2 are back-to-back inverters (latch circuits). Each of the functional block F1, F2 comprises a first and a second N-channel FET NF11, NF21, NF12, NF22 and a first and a second P-channel FET PF11, PF21, PF12, PF22. The drain of the first N-channel FET NF11 of the first functional block F1 is connected to the second node B and the drain of the first N-channel FET NF21 of the second functional block F2 is connected to the fourth node D.

The purpose of the functional block F1 is to hold the logical state of the second node B during an evaluating mode.

The purpose of the functional block F2 is to hold, during a hold mode, the logical state of the fourth node D which the fourth node D assumes during the preceding evaluating mode. The fourth node D is decoupled from the remainder of the flip-flop 1 during the hold mode and thus the output of the flip-flop 1 is driven by the second functional block F2. The output signal Q changes only when a leading edge LE of the clock signal CLK occurs.

If the reset is activated, then the reset signal RST is set to logical "0". Then, the output signal CLK' of the NAND gate 4 is logical "1". The reset signals RST is also fed to inverter 20 of the first circuit part 2a, thus turning on the N-channel FET 21. This causes the third node C to become logical "0" which in turn turns on the P-channel PO of the output stage OS. As a result, the fourth node D becomes logical "1" and the output signal Q of the flip-flop 1 becomes logical "0". The flip-flop 1 is reset.

Fig. 2 shows an example if the reset is activated at time t1 during a hold mode of the flip-flop 1. Since the flip-flop 1 cannot react instantaneously, the output signal Q will become "0" after a short transition.

Fig. 3 shows an example if the reset is activated at time t1' during the evaluating mode of the flip-flop 1. Since the flip-flop 1 cannot react instantaneously, the output signal Q will become "0" after a short transition.

The flip-flop 1 comprises further the second circuit part 2b of the reset circuit. The second circuit part 2a is also a back-to-back inverter (latch circuit) comprising a first and a second N-channel FET NR1, NR2 and a first and a second P-channel FET PR1, PR2. The drain of the first N-channel FET NR1 is connected to the third node C. The second circuit part 2b comprises further a third P-channel FET PR3 whose gate is connected to the gate of the first N-channel FET NR1 of the second circuit part 2b, constituting a fifth node E. The source of the third P-channel FET PR3 is connected to the supply voltage VDD and the drain is connected to the drain of the P-channel FET POB of the output stage OS.

The reset may be switched from "activated" to "deactivated" during a hold mode or during an evaluating mode of the flip-flop 1.

Fig. 2 shows an example if the reset is switched from "activated" to "deactivated" during a hold mode of the flip-flop 1 at time t2. Up to time t2 the reset is activated and the third node D is logical "0". The second circuit part 2b, which is a latch circuit, holds the state of the third node C. If the reset is deactivated at time t2, i.e. during a hold mode, then the pre-charge P-channel FETs PI and PM of the input stage IS and middle stage MS, respectively, are conducting so that the second node B and the third node C become logical "1". Since, however, the fourth node D is decoupled from the remainder of the flip-flop 1 during a hold mode and is driven by the second functional block F2, the state of the fourth node D remains "1" and the output signal Q of the flip-flop 1 is logical "0".

If the clock signal CLK transits from logical "0" to logical "1" at time t3, then the flip-flop 1 is again in its transparent evaluating mode and the output signal Q of the flip-flop 1 changes to the state corresponding to the input signal DA.

Fig. 3 shows an example if the reset is switched from "activated" to "deactivated" during an evaluating mode of the flip-flop 1 at time t2'. Up to time t2' the reset is activated and the third node D is logical "1". At time t2' the reset is deactivated. Since the pre-charge P-Channel FETs PI and PM of the input stage IS and the middle stage MS, respectively, are inactive during an evaluating mode, the third node C floats. The second circuit part 2b, which is a latch circuit, maintains the logical state of the third node C, i.e. the logical state of the third node C remains logical "0" during the evaluating mode. As a result, the logical state of the fourth node D remains "1" and the output signal Q of the flip-flop 1 remains "0". At time t3' the flip-flop 1 transits from an evaluating mode to a hold mode. The pre-charge P-channel FETs PI and PM of the input stage IS and middle stage MS, respectively, are conducting so that the second node B and the third node C become logical "1". Since, however, the fourth node D is decoupled from the remainder of the flip-flop 1 during a hold mode and is driven by the second functional block F2, the state of the fourth node D remains "1" and the output signal Q of the flip-flop 1 is logical "0".

If the clock signal CLK transits from logical "0" to logical "1" at time t3, then the flip-flop 1 is again in its transparent evaluating mode and the output signal Q of the flip-flop 1 changes to the state corresponding to the input signal DA.

As a result, the flip-flop 1 can only exit out of reset after a leading edge LE of the clock signal CLK has occurred. The flip-flop 1 is configured to synchronous exit out of reset.

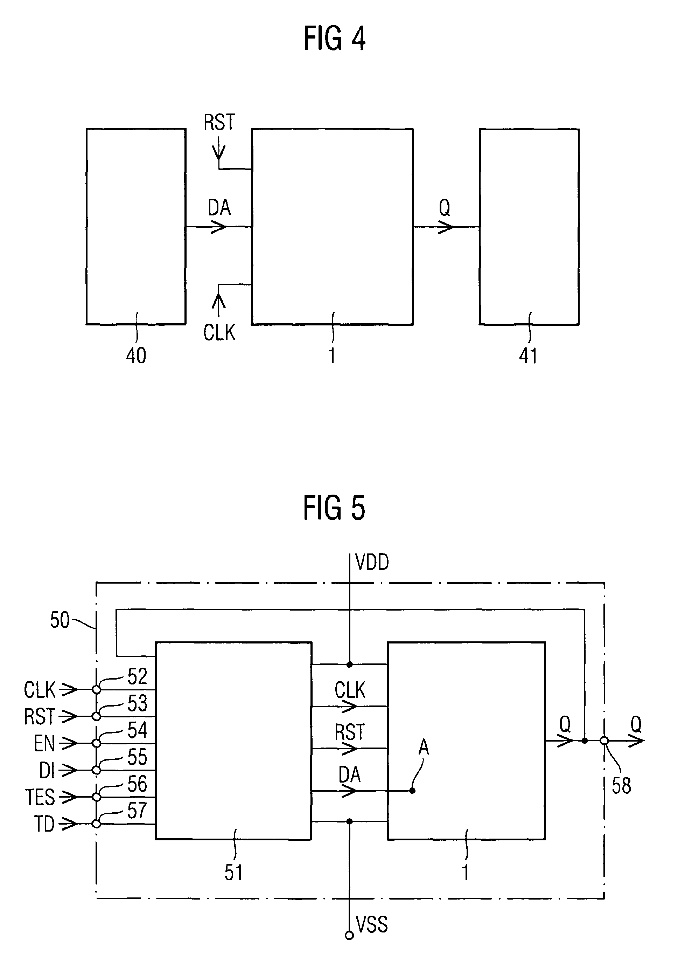

Since the TSPC flip-flop 1 has the N-Channel FET NID as its input, it can naturally be used as a level shifter as shown in Fig. 4. The TSPC flip-flop 1 is connected between a first circuit 40 and a second circuit 41. The two circuits 40 and 41 have different voltage levels for their logical signals. For the exemplary embodiment, the input signal DA of the TSPC flip-flop 1 is the output signal of circuit 40. The voltage level for logical "1" is VDD1. The output signal Q of the flip-flop 1 is the input signal of circuit 41. The voltage level for logical "1" is VDD. The voltage levels for the clock signal CLK and for the reset signal RST are VDD. The voltage level VDD may be greater or less than the voltage level of VDD1. The voltage levels VDD and VDD1 can also be the same.

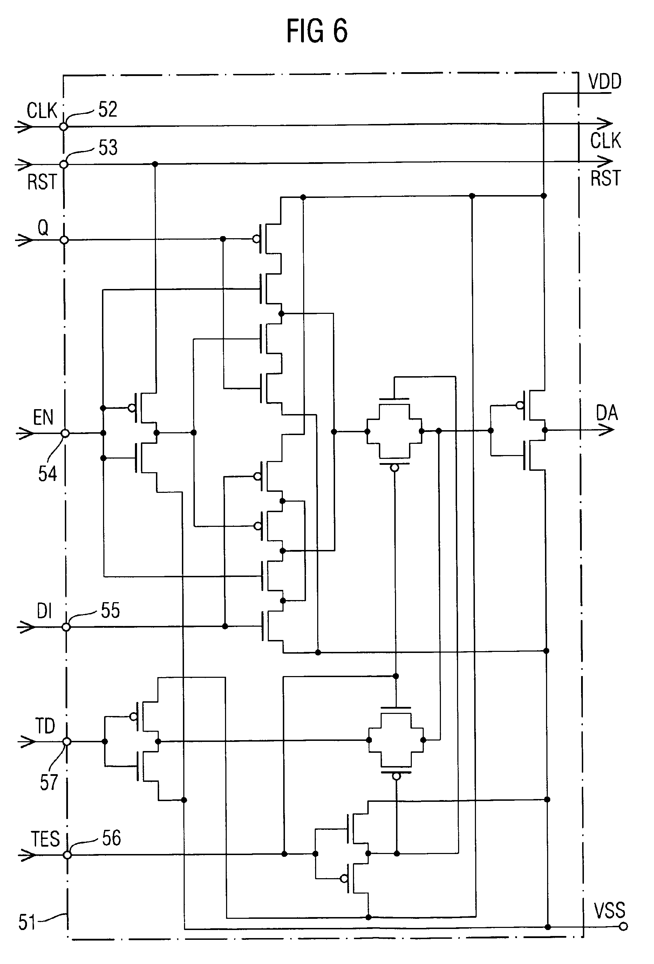

The TSPC flip-flop 1 can be used as a core flip-flop integrated into a wide range of integrated circuits. An example of such an integrated circuit 50 is shown in Fig. 5. The integrated circuit 50 is a combination of the TSPC flip-flop 1 with a standard cell interface 51. The circuit diagram of the standard cell interface 51 is depicted in Fig. 6.

For the exemplary embodiment of Fig. 6, the cell interface 51 is a combinatorial circuit and the integrated circuit 50 has an output 58 at which the flip-flop 1 output signal Q is present. The integrated circuit 50 has a clock input 52 at which the clock signal CLK is applied and a reset input 53 at which the reset signal RST is applied. The clock input 52 is connected to the first inverter 3 of the flip-flop 1. The reset input 53 is connected to the NAND gate 4 and the inverter 20 of the second circuit part 2b.

The integrated circuit 50 comprises further an enable input 54, an data input 55, a test enable input 56, and a test data input 57. Depending on an enable signal EN present at the enable input 54, a test enable signal TES at the test enable input 56, and a test data signal TD present at the test data input 57 the input signal DA for the flip-flop 1 assumes corresponding values while the reset is deactivated.

If the enable signal EN is logical "0", then the output signal Q of the integrated circuit 50 is frozen.

The enable may be switched from "activated" to "deactivated" during a hold mode or during an evaluating mode of the flip-flop 1. Then, the exit out of disable (enable signal EN equals logical "0") to enable (enable signal EN equals logical "1") behaves like the exit out of reset, i.e. the output-data Q is only up-dated at the next evaluating mode.

If the enabling signal EN transits from logical "0" to logical "1", then the output signal Q is up-dated at the next evaluating mode of the flip-flop 1, depending on the input signal DA of the flip-flop 1. If the test enable signal TES is logical "1", then the flip-flop 1 input signal DA equals to the test data TD, independent of the enable signal EN. If the enabling signal EN is logical "1" and the test enable signal TES is logical "0", then the flip-flop 1 input signal DA equals input data DI present at the data input 55.

If reset is activated, then the output signal Q is logical "0".

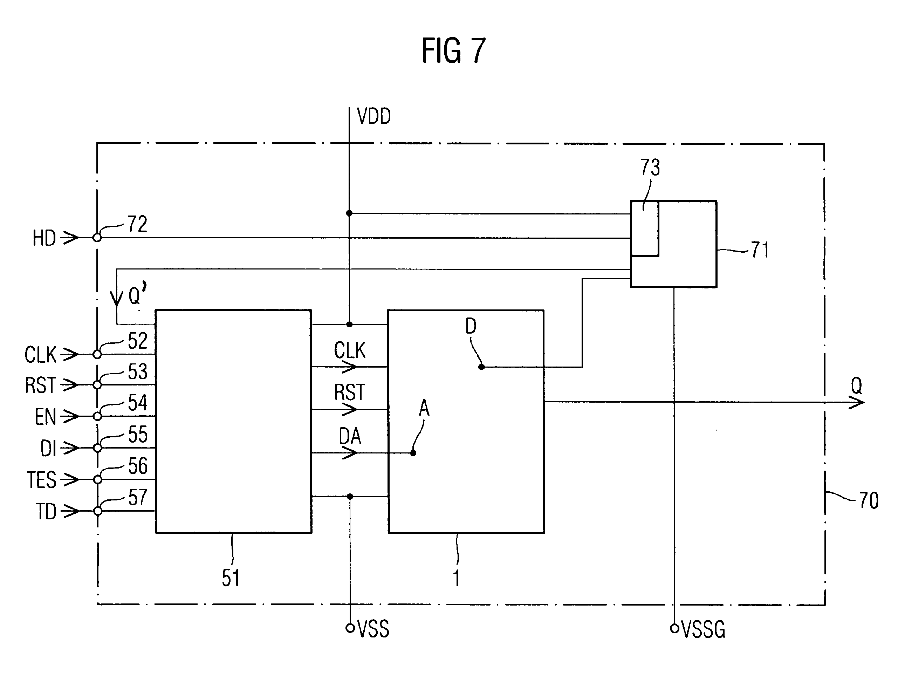

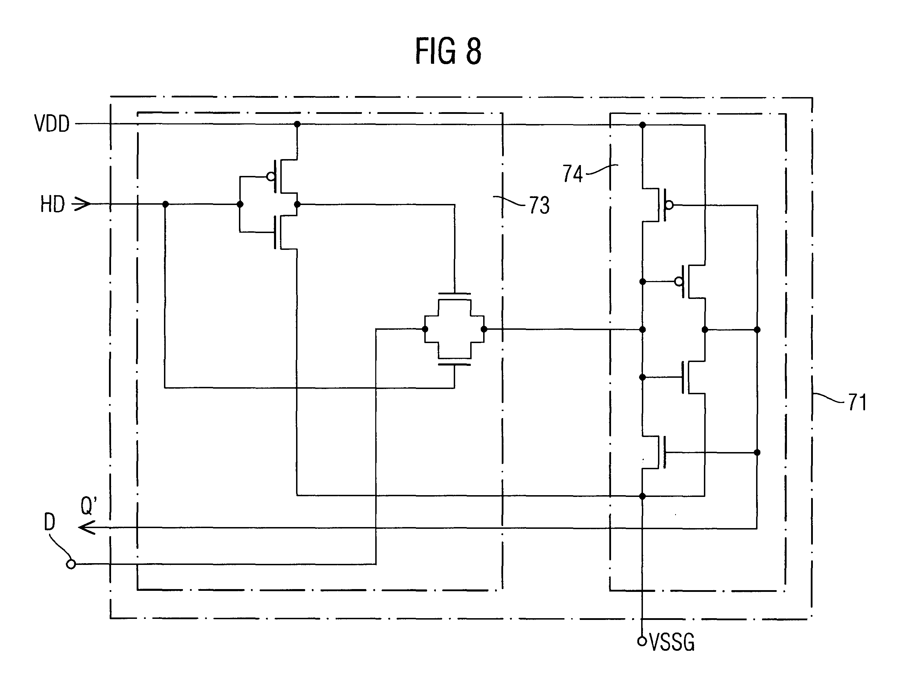

Fig. 7 shows an integrated circuit 70 which combines the TSPC flip-flop 1 with a state retention interface 71 and the standard cell interface. The integrated circuit 70 has, besides the clock input 52, the reset input 53, the enable input 54, the data input 55, the test enable input 56, and the test data input 57, an hold input 72, at which a hold signal HD is present. The state retention interface 71, whose circuit diagram is depicted in Fig. 8, comprises a transmission gate 73 controlled by the hold signal HD and a latch circuit 74. The latch circuit 74 is similar to the functional block F2. The latch circuit 74 generates an output signal Q'.

The state retention interface 71 is connected to the positive supply voltage VDD and to a node VSSG. Unlike the node VSS, which is connected to ground via a non-shown switch, the node VSSG is directly connected to ground.

As long as the hold signal HD is logical "0" node VSS is connected to ground. Then, the output signal Q of the flip-flop 1 which is also the output signal of the integrated circuit 70 is equal to the output signal Q' of the latch circuit 74.

Asserting a logical "1" hold signal HD implies that the switch connecting the node VSS to ground is turned off. Then, only the state retention interface 71, which is a relatively low leakage device, is powered by the positive supply voltage VDD, since node VSSG is still connected to ground. The transmission gate 73 is used to restore the last value stored when the power is turned back on, corresponding to a hold signal HD of logical "0". Further, all inputs of the integrated circuit 70 are floating.

Although modifications and changes may be suggested by those skilled in the art, it is the intention of the inventor to embody within the patent warranted heron all changes and modifications as reasonably and properly come within the scope of his contribution to the art.

List of reference signs
- 1: Flip-flop
- 2a: a first circuit part
- 2b: second circuit part
- 3: first inverter
- 4: NAND gate
- 5: inverter

- 20: inverter
- 21: N-channel FET

- 40, 41: circuit

- 50: integrated circuit
- 51: standard cell interface
- 52: clock input
- 53: reset input
- 54: enable input
- 55: data input
- 56: test enable input
- 57: test data input
- 58: output

- 70: integrated circuit
- 71: state retention interface
- 72: hold input
- 73: transmission gate

- A, B, C, D, E, VSS, VSSG: node
- CLK: clock signal
- CLK': output signal
- DA: input signal
- DI: data input signal
- EN: enable signal
- F1, F2: functional block
- LE: leading edge
- RST: reset signal
- TD: test data signal
- TES: enable signal
- IS: input stage
- MS: middle stage
- OS: output stage
- Q: output signal
- HD: hold signal
- VDD: supply voltage

- PI, PM, PO, POB: P-channel FET
- PR1, PR2, PF11, PR3: P-channel FET
- PF12, PF21, PF22: P-channel FET
- NI, NID, NM, NMD: N-channel FET
- NO, NOD, NF11: N-channel FET
- NF21, NF12, NF22: N-channel FET
- NR1, NR2: N-channel FET

## Claims

1. A True Single Phase Clock flip-flop configured to operate in an evaluating and an hold mode, comprising, as integral parts of said flip-flop (1):
an input stage (OS) having an input node (A) and a first output node (B);
a middle stage (MS) having a second output node (C);
an output stage (OS) having a third output node (D); and
a reset functional block (2a, 2b) being switchable between an activated and an deactivated mode; said reset functional block (2a, 2b) resetting said flip-flop (1) when activated and being configured to synchronous exit out of reset when switched from its activated to its deactivated mode so that an output signal (Q) of said flip-flop (1) is only up-dated when said flip-flop (1) changes to its next evaluating mode.

2. The flip-flop of claim 1, wherein said third output node (D) is decoupled from the remainder of said flip-flop (1) during said hold mode.

3. The flip-flop of claim 2, wherein said reset functional block comprises a first functional block (2a) which forces said second output node (C) to a predefined state so that said third output node (D) is forced to a state corresponding to a reset output signal (Q).

4. The flip-flop of claim 2, wherein said reset functional block comprises a second functional block (2b) which maintains said predefined state of said second output node (C), when said reset functional block (2a) is switched from its activated to its deactivated mode during a certain of said evaluating modes, up to said hold mode immediately following said certain evaluating mode.

5. The flip-flop of claim 4, wherein said second functional block comprises a first latch circuit (2b).

6. The flip-flop of claim 5, wherein said first latch circuit (2b) maintains the state of said second output node (C) during a given evaluating mode.

7. The flip-flop of claim 5 or 6, wherein said first latch circuit is a back-to-back inverter.

8. The flip-flop of one of the claims 1 to 7, wherein said reset functional block (2a, 2b) is connected between said middle state (MS) and said output stage (OS).

9. The flip-flop of one of the claims 1 to 8, comprising a second latch circuit (F2) being connected to said third output node (D); said second latch circuit (F2) being able to toggle between a first state and a second state and holding, during said hold mode, the value of said third output node (D) assumed during said evaluating mode preceding said hold mode.

10. The flip-flop of claim 9, wherein said second latch circuit (F2) is a back-to-back inverter.

11. The flip-flop of one of the claims 1 to 10, comprising a third latch circuit (F1) being connected to said first output node (B); said first latch circuit (F1) being able to toggle between a first state and a second state and holding, during said evaluating mode, the value of said first output node (B) assumed during said evaluating mode.

12. The flip-flop of claim 11, wherein said third latch circuit (F1) is a back-to-back inverter.

13. A level shifting flip-flop, comprising a flip-flop (1) of one of the claims 1 to 12.

14. An integrated circuit, comprising:
said TSPC flip-flop (1) of one of the claims 1 to 12; and
a standard cell interface (51).

15. The integrated circuit of claim 14, comprising a state retention circuit (71).

16. An integrated circuit, comprising:
said TSPC flip-flop (1) of one of the claims 1 to 12; and
a state retention circuit (71).
